# EUROPEAN PATENT APPLICATION

(11) **EP 4 694 643 A1**
(43) Date of publication of application: **11.02.2026**
(21) Application number: 25186202.5
(22) Date of filing: 30.06.2025
(51) Int. Cl.: H10K 59/122

(54) **DISPLAY DEVICE AND METHOD OF MANUFACTURING THE SAME**

(30) Priority: 05.08.2024 KR 20240103582
(71) Applicant: Samsung Display Co., Ltd., Yongin-si, Gyeonggi-do 17113 (KR)
(72) Inventor: LI, XINXING, 17113 Yongin-si (KR)
(74) Representative: Taor, Simon Edward William

(57) **Abstract**

A display device includes a base layer, a first electrode above the base layer, a pixel-defining layer above the base layer, defining a pixel opening through which the first electrode is exposed, and including a concave area extending from the pixel opening to an inner side of the pixel-defining layer, a support pattern above the first electrode in the concave area, and including a lower support pattern between the first electrode and the pixel-defining layer, and an upper support pattern between the lower support pattern and the pixel-defining layer, one portion of the upper support pattern overlapping the lower support pattern, and another portion of the upper support pattern offset from the lower support pattern in plan view and spaced apart from the first electrode, a first light-emitting pattern above the first electrode, and a second electrode above the first light-emitting pattern.

## Description

### CROSS-REFERENCE TO RELATED APPLICATION

The present application claims priority to, and the benefit of, Korean Patent Application No. 10-2024-0103582, filed on August 5, 2024, in the Korean Intellectual Property Office.

### BACKGROUND

### 1. Field

The present disclosure relates to a display device including an organic layer, and a method of manufacturing the display device.

### 2. Description of the Related Art

Electronic devices, such as a smart phone, a tablet computer, a digital camera, a notebook computer, a navigation device, a television set, or the like, which are able to provide a user with images, include a display panel to display the images.

The display device includes light-emitting areas defined by light-emitting elements to display colors. The light-emitting areas respectively include light-emitting layers each with a different color, and are driven independently by pixel circuits. The light-emitting element includes an organic layer to improve a light emission efficiency, and the organic layer is provided as a single layer shared by the light-emitting areas. When the organic layer is provided as a single layer, a defect, such as a lateral leakage current, may occur between the light-emitting areas adjacent to each other.

### SUMMARY

The present disclosure provides a display device with improved display quality.

The present disclosure provides a method of manufacturing the display device.

Embodiments of the present disclosure provide a display device including a base layer, a first electrode above the base layer, a pixel-defining layer above the base layer, defining a pixel opening through which the first electrode is exposed, and including a concave area extending from the pixel opening to an inner side of the pixel-defining layer, a support pattern above the first electrode in the concave area, and including a lower support pattern between the first electrode and the pixel-defining layer, and an upper support pattern between the lower support pattern and the pixel-defining layer, one portion of the upper support pattern overlapping the lower support pattern, and another portion of the upper support pattern offset from the lower support pattern in plan view and spaced apart from the first electrode, a first light-emitting pattern above the first electrode, and a second electrode above the first light-emitting pattern.

The lower support pattern may include a conductive material.

The upper support pattern may include an inorganic insulating material.

The first light-emitting pattern may further include at least one of a hole control layer or an electron control layer.

The display device may further include a charge generation layer above the first light-emitting pattern, and a second light-emitting pattern above the charge generation layer.

The first light-emitting pattern may include a first portion above the pixel-defining layer, and a second portion in the pixel opening, and electrically insulated from the first portion.

The lower support pattern may have a thickness that is greater than a thickness of the second portion of the first light-emitting pattern, and that is less than a sum of the thickness of the second portion of the first light-emitting pattern and a thickness of the second electrode.

The first electrode may include a first edge, a second edge facing the first edge in a first direction in plan view, a third edge, and a fourth edge facing the third edge in a second direction crossing the first direction in plan view, wherein the concave area corresponds to only one of the first, second, third, or fourth edges.

The first electrode may include a first edge, a second edge facing the first edge in a first direction in plan view, a third edge, and a fourth edge facing the third edge in a second direction crossing the first direction in plan view, wherein the concave area includes a first concave area corresponding to the first edge, and a second concave area corresponding to the second edge.

The first light-emitting pattern may include a first portion above the pixel-defining layer, and a second portion in the pixel opening, electrically insulated from the first portion in the first direction, and electrically connected to the first portion in the second direction.

The concave area may further include a third concave area corresponding to the third edge, and a fourth concave area corresponding to the fourth edge.

The first electrode may include a first edge, a second edge facing the first edge in a first direction in plan view, a third edge, and a fourth edge facing the third edge in a second direction crossing the first direction in plan view, wherein the concave area is provided in plurality to correspond to at least one of the first, second, third, or fourth edges, and wherein the pixel-defining layer contacts the first electrode between adjacent ones of the concave areas.

The support pattern may be provided in plurality, the support patterns respectively corresponding to the concave areas, and not located between the adjacent ones of the concave areas.

Embodiments of the present disclosure provide an electronic device including a window, a housing coupled with the window, and a display module under the window, the display module including a base layer, a first electrode above the base layer, a pixel-defining layer above the base layer, defining a pixel opening through which the first electrode is exposed, and including a first portion offset from the first electrode in plan view, and a second portion overlapping the first electrode, a support pattern above the first electrode, offset from the first portion of the pixel-defining layer in plan view, overlapping the second portion, and including a lower support pattern between the first electrode and the second portion, and an upper support pattern between the lower support pattern and the second portion, and including a portion extending further than the lower support pattern and spaced apart from the first electrode, a first light-emitting pattern above the first electrode, and a second electrode above the first light-emitting pattern.

The upper support pattern may have a width that is greater than a width of the lower support pattern.

The first electrode may include a first edge, a second edge facing the first edge in a first direction in plan view, a third edge, and a fourth edge facing the third edge in a second direction crossing the first direction in plan view, wherein the second portion of the pixel-defining layer corresponds to at least one of the first, second, third, or fourth edges.

The first electrode may include a first edge, a second edge facing the first edge in a first direction in plan view, a third edge, and a fourth edge facing the third edge in a second direction crossing the first direction in plan view, wherein the second portion of the pixel-defining layer is provided in plurality to correspond to at least one of the first, second, third, or fourth edges, and wherein the first portion is between adjacent ones of the second portions.

Embodiments of the present disclosure provide a method of manufacturing a display device, the method including forming a first electrode, a preliminary upper support pattern, and a preliminary lower support pattern above a base layer, forming a pixel-defining layer defining a pixel opening exposing the first electrode above the preliminary upper support pattern and the preliminary lower support pattern, etching the preliminary upper support pattern to form an upper support pattern overlapping the pixel-defining layer, etching the preliminary lower support pattern to form a lower support pattern that is overlapped by a portion of the upper support pattern, and that is offset from another portion of the upper support pattern in plan view, the other portion of the upper support pattern being spaced apart from the first electrode, and forming a first light-emitting pattern and a second electrode above the pixel-defining layer and the first electrode.

The etching of the preliminary upper support pattern may include a dry etching process, wherein the etching of the preliminary lower support pattern includes a wet etching process.

The etching of the preliminary lower support pattern may include isotropic etching.

According to an aspect, there is provided a display device as set out in claim 1. Additional features are set out in claims 2 to 12. According to an aspect, there is provided an electronic device as set out in claim 13. According to an aspect, there is provided a method as set out in claim 14. Additional features are set out in claim 15.

According to the above, because the lower support pattern and the upper support pattern are located in the concave area, which extends toward the inner side of the pixel-defining layer, deformation of the pixel-defining layer in a high temperature process is reduced or prevented, and a structural stability of the pixel-defining layer is improved. Accordingly, a lateral leakage current between pixels adjacent to each other is reduced, and the pixels provide a light emission luminance corresponding to grayscale values. Because the upper support pattern and the lower support pattern are formed using the same mask, an additional mask is not needed.

According to the above, the support pattern is located in some of the edges of the first electrode and is not located in the other of the edges of the first electrode, and thus, a current path between the pixels adjacent to each other is sufficiently secured.

### BRIEF DESCRIPTION OF THE DRAWINGS

The above and other aspects of the present disclosure will become readily apparent by reference to the following detailed description when considered in conjunction with the accompanying drawings wherein:
FIG. 1A is a perspective view of a display device according to one or more embodiments of the present disclosure;
FIG. 1B is an exploded perspective view of a display device according to one or more embodiments of the present disclosure;
FIG. 2 is a cross-sectional view of a display module according to one or more embodiments of the present disclosure;
FIG. 3 is a plan view of a display panel according to one or more embodiments of the present disclosure;
FIG. 4 is an enlarged plan view of a display area of a display panel according to one or more embodiments of the present disclosure;
FIG. 5A is a cross-sectional view of a display panel taken along the line I-I' of FIG. 4 according to one or more embodiments of the present disclosure;
FIG. 5B is an enlarged cross-sectional view of an area AA' of FIG. 5A;
FIG. 5C is a cross-sectional view of a display panel taken along the line II-II' of FIG. 4 according to one or more embodiments of the present disclosure;
FIG. 5D is an enlarged plan view of a pixel of FIG. 3;
FIGS. 6A to 6C are enlarged plan views of a portion of a display area according to embodiments of the present disclosure;
FIG. 7A is an enlarged plan view of a pixel according to one or more embodiments of the present disclosure;
FIG. 7B is a cross-sectional view taken along the line A-A' of FIG. 7A;
FIG. 7C is an enlarged plan view of a concave area of FIG. 7A;
FIG. 8 is an enlarged cross-sectional view of a portion of a light-emitting element according to one or more embodiments of the present disclosure; and
FIGS. 9A to 9G are cross-sectional views of a method of manufacturing a display device according to one or more embodiments of the present disclosure.

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

In the drawings, the relative sizes of elements, layers, and regions may be exaggerated for clarity and/or descriptive purposes. In other words, because the sizes and thicknesses of elements in the drawings are arbitrarily illustrated for convenience of description, embodiments of the disclosure are not limited thereto. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the illustrated shapes of elements, layers, or regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Spatially relative terms, such as "beneath," "below," "lower," "lower side," "under," "above," "upper," "over," "higher," "upper side," "side" (e.g., as in "sidewall"), and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component (e.g., an apparatus, a device, a circuit, a wire, an electrode, a terminal, a conductive film, etc.) is referred to as being "formed on," "on," "connected to," or "(operatively, functionally, or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a transistor, a resistor, an inductor, a capacitor, a diode and/or the like. Accordingly, a connection is not limited to the connections illustrated in the drawings or the detailed description and may also include other types of connections. In describing embodiments, an expression of connection indicates electrical connection unless explicitly described to be direct connection, and "directly connected/directly coupled," or "directly on," refers to one component directly connecting or coupling another component, or being on another component, without an intermediate component.

In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XY, YZ, and XZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list. When "C to D" is stated, it means C or more and D or less, unless otherwise specified.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are only used to distinguish one element, member, component, region, area, layer, section, or portion from another element, member, component, region, area, layer, section, or portion. Thus, a first element, component, region, layer or section described below could be termed a second element, component, region, layer or section, without departing from the scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

When one or more embodiments may be implemented differently, a specific process order may be performed differently from the described order. For example, two consecutively described processes may be performed substantially at the same time or performed in an order opposite to the described order.

As used herein, the terms "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure." Furthermore, the expression "being the same" may mean "being substantially the same". In other words, the expression "being the same" may include a range that can be tolerated by those of ordinary skill in the art. The other expressions may also be expressions from which "substantially" has been omitted.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

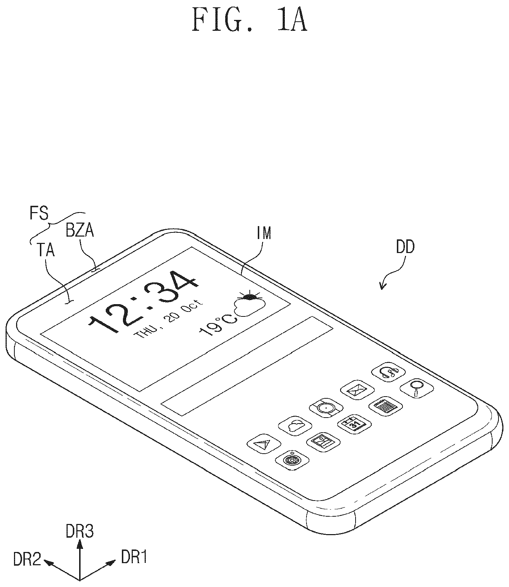

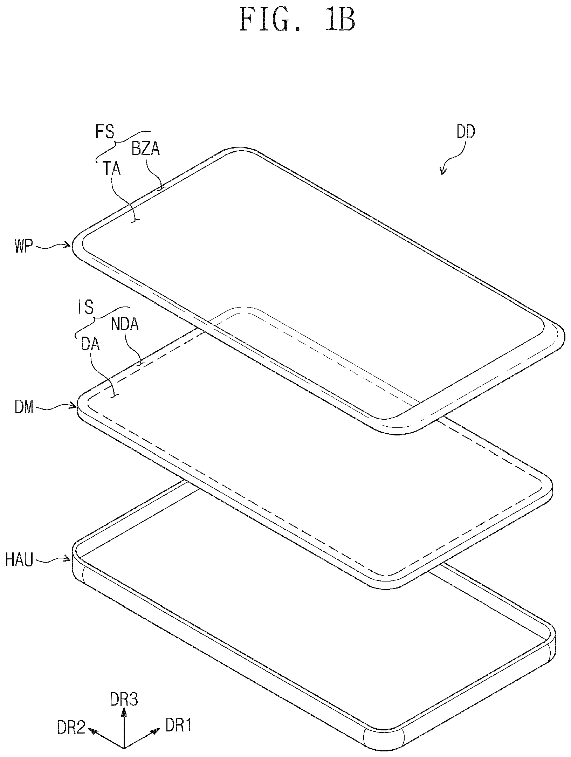

FIG. 1A is a perspective view of a display device DD according to one or more embodiments of the present disclosure, and FIG. 1B is an exploded perspective view of the display device DD according to one or more embodiments of the present disclosure.

The display device DD may be applied to a large-sized electronic item, such as a television set, a monitor, or an outdoor billboard. In addition, the display device DD may be applied to small- and medium-sized electronic items, such as a personal computer, a notebook computer, a personal digital assistant, a car navigation unit, a game unit, a smartphone, a tablet computer, and a camera. However, these are merely examples, and the display device DD may be employed in other display devices as long as they do not deviate from the concept of the present disclosure. The smartphone will be described as a representative example of the display device DD.

Referring to FIGS. 1A and 1B, the display device DD may display an image IM through a display surface FS, which is substantially parallel to each of a first direction DR1 and a second direction DR2, toward a third direction DR3. The third direction DR3 may be a normal line direction with respect to a plane defined by the first and second directions DR1 and DR2. The image IM may include a video and a still image. FIG. 1A shows a clock widget and application icons as a representative example of the image IM. The display surface FS through which the image IM is displayed may correspond to a front surface of the display device DD.

Front (or upper) and rear (or lower) surfaces of each member of the display device DD may be defined with respect to a direction in which the image IM is displayed. The front and rear surfaces may be opposite to each other in the third direction DR3, and a normal line direction of each of the front and rear surfaces may be substantially parallel to the third direction DR3. Meanwhile, directions indicated by the first, second, and third directions DR1, DR2, and DR3 may be relative to each other, and thus, the directions indicated by the first, second, and third directions DR1, DR2, and DR3 may be changed to other directions. In the following descriptions, the expression "when viewed in a plane," or "in plan view" means a state of being viewed in the third direction DR3.

The display device DD may include a window WP, a display module DM, and a housing HAU. The window WP and the housing HAU may be coupled to each other to provide an exterior of the display device DD.

The window WP may include an optically transparent insulating material. For example, the window WP may include a glass or plastic material. A front surface of the window WP may define the display surface FS of the display device DD. The display surface FS may include a transmissive area TA and a bezel area BZA. The transmissive area TA may be an optically transparent area. For example, the transmissive area TA may be an area having a visible light transmittance of about 90% or more.

The bezel area BZA may be an area having a relatively lower transmittance than that of the transmissive area TA. The bezel area BZA may define a shape of the transmissive area TA. The bezel area BZA may be located adjacent to the transmissive area TA and may surround the transmissive area TA. However, this is merely one example, and the bezel area BZA may be omitted from the window WP in one or more embodiments. The window WP may include at least one functional layer of an anti-fingerprint layer, a hard coating layer, or an anti-reflective layer, and should not be particularly limited.

The display module DM may be located under the window WP. The display module DM may have a configuration that substantially generates the image IM. The image IM generated by the display module DM may be displayed through a display surface IS of the display module DM and may be viewed by a user through the transmissive area TA.

The display module DM may include a display area DA and a non-display area NDA. The display area DA may be activated in response to electrical signals. The non-display area NDA may be adjacent to the display area DA. The non-display area NDA may surround the display area DA (e.g., in plan view). The non-display area NDA may be covered by the bezel area BZA and may not be viewed from the outside.

The housing HAU may be coupled with the window WP. The housing HAU and the window WP coupled to the housing HAU may provide an inner space. The display module DM may be accommodated in the inner space.

The housing HAU may include a material with a relatively high rigidity. For example, the housing HAU may include a glass, plastic, or metal material or a plurality of frames and/or plates of combinations thereof. The housing HAU may stably protect the components of the display device DD accommodated in the inner space from external impacts.

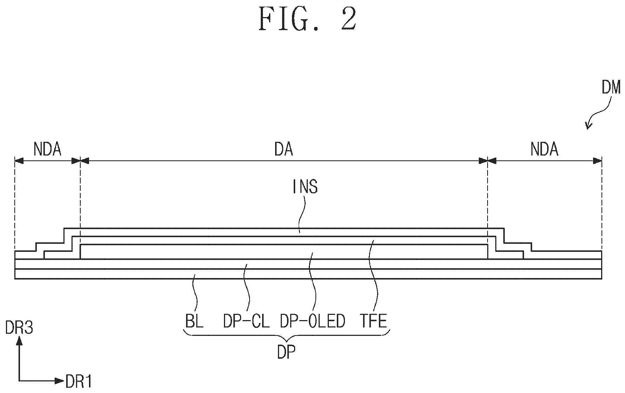

FIG. 2 is a cross-sectional view of the display module DM according to one or more embodiments of the present disclosure.

Referring to FIG. 2, the display module DM may include a display panel DP and an input sensor INS. In one or more embodiments, the display device DD (refer to FIG. 1A) may further include a protective member located on a lower surface of the display panel DP, or an anti-reflective member and/or a window member located on an upper surface of the input sensor INS.

The display panel DP may be a light-emitting type display panel, although it should not be particularly limited. For example, the display panel DP may be an organic light-emitting display panel or an inorganic light-emitting display panel. A light-emitting layer of the organic light-emitting display panel may include an organic light-emitting material. A light-emitting layer of the inorganic light-emitting display panel may include a quantum dot, a quantum rod, or a micro-LED. Hereinafter, the organic light-emitting display panel will be described as the display panel DP.

The display panel DP may include a base layer BL, a circuit element layer DP-CL, a display element layer DP-OLED, and a thin film encapsulation layer TFE. The circuit element layer DP-CL, the display element layer DP-OLED, and the thin film encapsulation layer TFE may be located on the base layer BL (as used herein, "located on" may mean "above"). The input sensor INS may be located directly on the thin film encapsulation layer TFE. In the present disclosure, the expression "A component A is located directly on a component B." means that no adhesive layers are present between the component A and the component B.

The base layer BL may include at least one plastic film. The base layer BL may be a flexible substrate and may include a plastic substrate, a glass substrate, a metal substrate, or an organic/inorganic composite material substrate. In the present disclosure, the display area DA and the non-display area NDA described with reference to FIG. 1B may be defined in the base layer BL.

The circuit element layer DP-CL may include at least one insulating layer and a circuit element. The insulating layer may include at least one inorganic layer and at least one organic layer. The circuit element may include signal lines and a pixel driving circuit.

The display element layer DP-OLED may include a barrier wall and a light-emitting element. The light-emitting element may include an anode, an intermediate layer, and a cathode.

The thin film encapsulation layer TFE may include a plurality of thin layers. Some thin layers may be located to improve an optical efficiency, and some thin layers may be located to protect organic light-emitting diodes.

The input sensor INS may obtain coordinate information of an external input. The input sensor INS may have a multi-layer structure. The input sensor INS may include a conductive layer having a single-layer or multi-layer structure. The input sensor INS may include an insulating layer having a single-layer or multi-layer structure. The input sensor INS may sense the external input by a capacitive method. However, the operation method of the input sensor INS should not be particularly limited. The input sensor INS may sense the external input by an electromagnetic induction method or a pressure sensing method. According to one or more embodiments, the input sensor INS may be omitted.

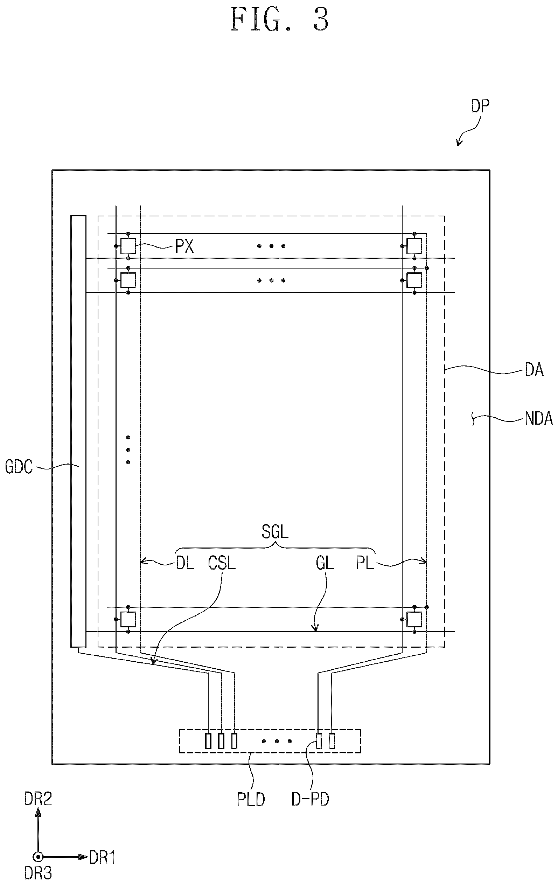

FIG. 3 is a plan view of the display panel DP according to one or more embodiments of the present disclosure.

Referring to FIG. 3, the display panel DP may include the display area DA, and the non-display area NDA around the display area DA. The display panel DP may include pixels PX and signal lines SGL electrically connected to the pixels PX. The display panel DP may include a driving circuit GDC and a pad part PLD. The display area DA and the non-display area NDA may be distinguished from each other by a presence or absence of the pixels PX. The pixels PX may be located in the display area DA. The driving circuit GDC and the pad part PLD may be located in the non-display area NDA.

The pixels PX may be arranged in the first direction DR1 and the second direction DR2. The pixels PX may include a plurality of pixel rows extending in the first direction DR1 and arranged in the second direction DR2, and a plurality of pixel columns extending in the second direction DR2 and arranged in the first direction DR1.

The signal lines SGL may include gate lines GL, data lines DL, a power line PL, and a control signal line CSL. Each of the gate lines GL may be connected to a corresponding pixel among the pixels PX, and each of the data lines DL may be connected to a corresponding pixel among the pixels PX. The power line PL may be electrically connected to the pixels PX. The control signal line CSL may be connected to the driving circuit GDC, and may provide control signals to the driving circuit GDC.

The driving circuit GDC may include a gate-driving circuit. The gate-driving circuit may generate gate signals, and may sequentially output the generated gate signals to the gate lines GL. The gate-driving circuit may further output another control signal to the pixel driving circuit.

The pad part PLD may be connected to a flexible circuit board, in one or more embodiments. The pad part PLD may include pixel pads D-PD, and the pixel pads D-PD may be pads that connect the flexible circuit board to the display panel DP. Each of the pixel pads D-PD may be connected to a corresponding signal line among the signal lines SGL. The pixel pads D-PD may be connected to corresponding pixels PX via the signal lines SGL. In addition, one pixel pad among the pixel pads D-PD may be connected to the driving circuit GDC.

In addition, the pad part PLD may further include input pads. In one or more embodiments, the input pads may be pads that connect the flexible circuit board to the input sensor INS (refer to FIG. 2), although embodiments of the present disclosure should not be limited thereto or thereby. According to one or more embodiments, the input pads may be located in the input sensor INS (refer to FIG. 2), and may be connected to a separate circuit board different from the flexible circuit board to which the pixel pads D-PD are connected. According to one or more embodiments, the input sensor INS (refer to FIG. 2) may be omitted, and may not further include the input pads.

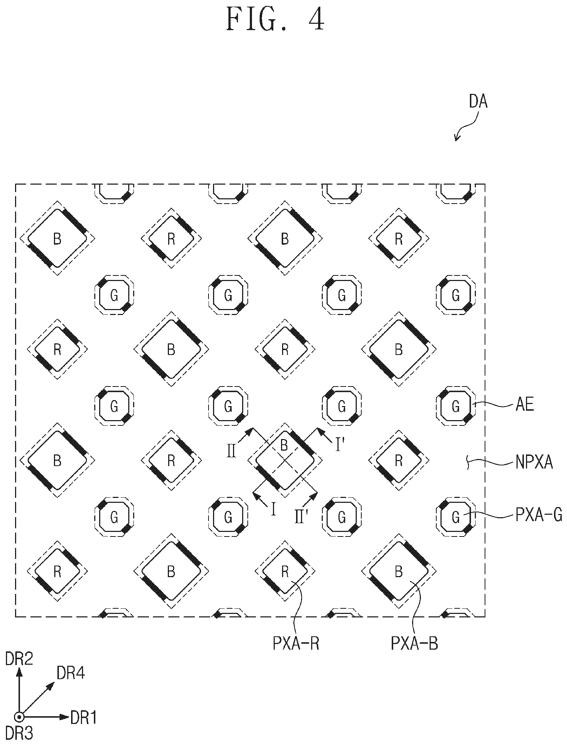

FIG. 4 is an enlarged plan view of the display area DA of the display panel DP (refer to FIG. 2) according to one or more embodiments of the present disclosure.

FIG. 4 is a plan view showing the display module DM when viewed from the above of the display surface IS (refer to FIG. 1B) of the display module DM (refer to FIG. 1B), and shows an arrangement of light-emitting areas PXA-R, PXA-G, and PXA-B.

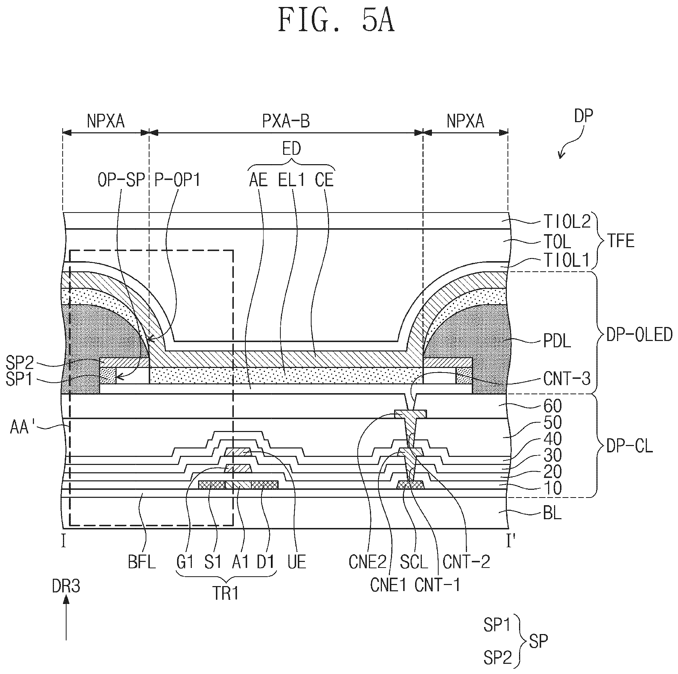

Referring to FIG. 4, the display area DA may include first, second, and third light-emitting areas PXA-R, PXA-G, and PXA-B, and a peripheral area NPXA surrounding the first, second, and third light-emitting areas PXA-R, PXA-G, and PXA-B (e.g., in plan view). The first, second, and third light-emitting areas PXA-R, PXA-G, and PXA-B may respectively correspond to areas from which lights provided from light-emitting elements ED1, ED2, and ED3 (refer to FIG. 5A) are emitted. The first, second, and third light-emitting areas PXA-R, PXA-G, and PXA-B may be distinguished by colors of the lights emitted outward from the display module DM (refer to FIG. 2).

The first, second, and third light-emitting areas PXA-R, PXA-G, and PXA-B may respectively provide first, second, and third color lights having colors different from each other. As an example, the first color light may be a red light, the second color light may be a green light, and the third color light may be a blue light. However, the first, second, and third color lights should not be limited thereto or thereby.

Each of the first, second, and third light-emitting areas PXA-R, PXA-G, and PXA-B may be defined as an area through which a portion of an upper surface of a first electrode AE is exposed by a light-emitting opening described later. The first electrode AE depicted by a dotted line in FIG. 4 may surround the first, second, and third light-emitting areas PXA-R, PXA-G, and PXA-B. The peripheral area NPXA may define a boundary between the first, second, and third light-emitting areas PXA-R, PXA-G, and PXA-B and may reduce or prevent a mixture of the colors of the lights between the first, second, and third light-emitting areas PXA-R, PXA-G, and PXA-B.

Each of the first, second, and third light-emitting areas PXA-R, PXA-G, and PXA-B may be provided in plural and may be repeatedly arranged in a corresponding (e.g., predetermined) arrangement within the display area DA. As an example, the first and third light-emitting areas PXA-R and PXA-B may be alternately arranged with each other in the first direction DR1 to form a first group. The second light-emitting areas PXA-G may be arranged in the first direction DR1 to form a second group. Each of the first group and the second group may be provided in plural, and the first groups may be alternately arranged with the second groups in the second direction DR2.

One second light-emitting area PXA-G may be spaced apart from one first light-emitting area PXA-R or one third light-emitting area PXA-B in a fourth direction DR4. The fourth direction DR4 may correspond to a direction between the first and second directions DR1 and DR2.

FIG. 4 shows a representative example of the arrangement of the first, second, and third light-emitting areas PXA-R, PXA-G, and PXA-B, and the arrangement of the first, second, and third light-emitting areas PXA-R, PXA-G, and PXA-B should not be particularly limited and may be changed in various ways. The first, second, and third light-emitting areas PXA-R, PXA-G, and PXA-B may be arranged in a PENTILE^{™} pattern (PENTILE^{™} being a registered trademark of Samsung Display Co., Ltd., Republic of Korea), as shown in FIG. 4. According to one or more embodiments, the first, second, and third light-emitting areas PXA-R, PXA-G, and PXA-B may be arranged in a stripe pattern or a diamond pattern (e.g., Diamond Pixel^{™}, Diamond Pixel^{™} being a registered trademark of Samsung Display Co., Ltd., Republic of Korea).

Each of the first, second, and third light-emitting areas PXA-R, PXA-G, and PXA-B may have a variety of shapes when viewed in a plane (in a plan view). As an example, each of the first, second, and third light-emitting areas PXA-R, PXA-G, and PXA-B may have a polygonal shape, a circular shape, or an oval shape. In FIG. 4, the first and third light-emitting areas PXA-R and PXA-B each having a rounded rectangular shape, and the second light-emitting area PXA-G having an octagonal shape are shown as a representative example.

The first, second, and third light-emitting areas PXA-R, PXA-G, and PXA-B may have substantially the same shape as each other when viewed in the plane, or at least one of the first, second, or third light-emitting areas PXA-R, PXA-G, or PXA-B may have a shape different from the others. FIG. 4 shows a structure in which the first and third light-emitting areas PXA-R and PXA-B generally have the same shape as each other when viewed in the plane, and the second light-emitting area PXA-G has the shape different from that of the first and third light-emitting areas PXA-R and PXA-B as a representative example.

At least one of the first, second, or third light-emitting areas PXA-R, PXA-G, or PXA-B may have a size different from those of the others when viewed in the plane. The size of the first light-emitting area PXA-R emitting the red light may be greater than the size of the second light-emitting area PXA-G emitting the green light, and may be smaller than the size of the third light-emitting area PXA-B emitting the blue light. However, a size relationship between the first, second, and third light-emitting areas PXA-R, PXA-G, and PXA-B according to the colors of the emitted lights should not be limited thereto or thereby, and may be changed in various ways depending on a design of the display module DM (refer to FIG. 2). In addition, according to one or more embodiments, the first, second, and third light-emitting areas PXA-R, PXA-G, and PXA-B may have substantially the same size as each other when viewed in the plane.

The shape, size, and arrangement of the first, second, and third light-emitting areas PXA-R, PXA-G, and PXA-B of the display module DM (refer to FIG. 2) may be variously designed depending on the colors of the emitted lights, the size of the display module DM (refer to FIG. 2), and the configuration of the display module DM (refer to FIG. 2), and they should not be limited to the one or more embodiments corresponding to FIG. 4.

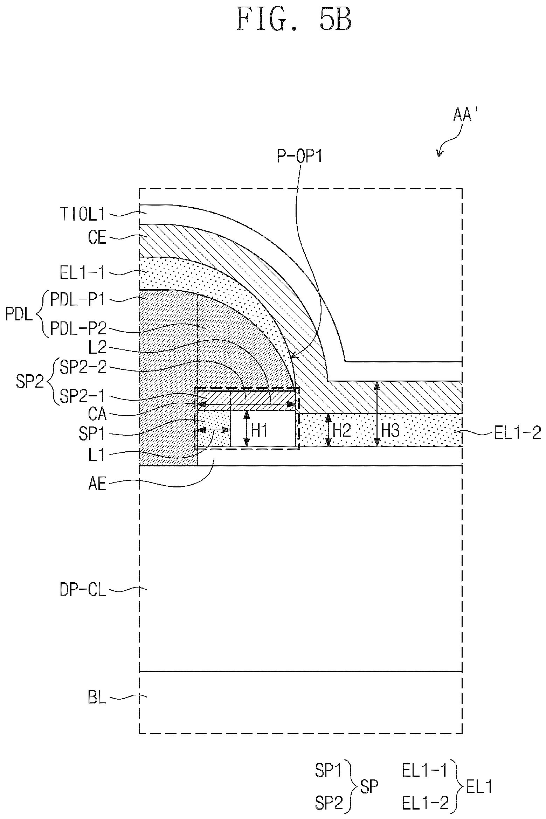

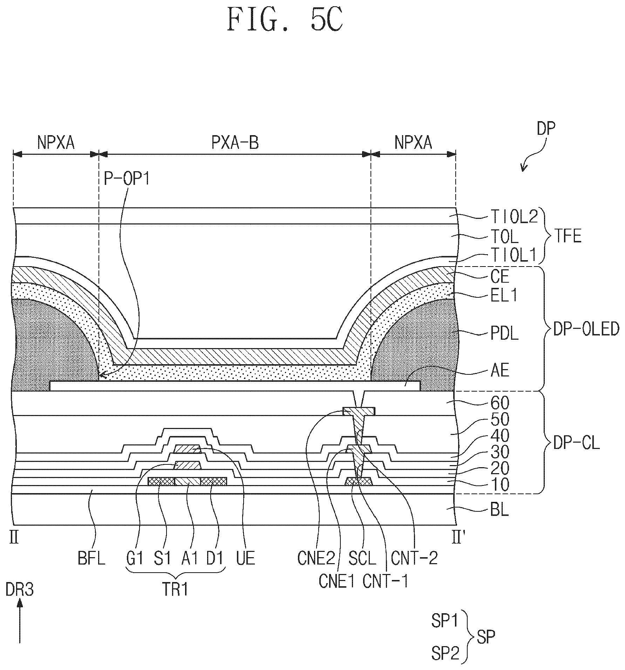

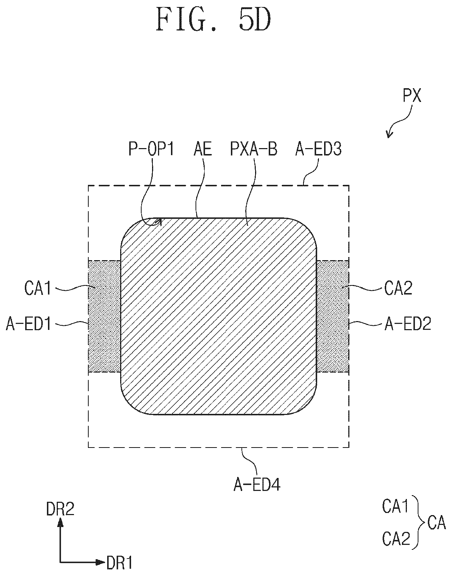

FIG. 5A is a cross-sectional view of the display panel DP taken along the line I-I' of FIG. 4 according to one or more embodiments of the present disclosure, and FIG. 5B is an enlarged cross-sectional view of an area AA' of FIG. 5A. FIG. 5C is a cross-sectional view of the display panel DP taken along the line II-II' of FIG. 4 according to one or more embodiments of the present disclosure, and FIG. 5D is an enlarged plan view of a pixel PX of FIG. 3.

In FIG. 5A, the same reference numerals denote the same elements in FIG. 2, and thus, detailed descriptions of the same elements will be omitted. FIG. 5A is a cross-sectional view of a portion of the third light-emitting area PXA-B of FIG. 4, and the first light-emitting area PXA-R or the second light-emitting area PXA-G may have substantially the same stack structure as the third light-emitting area PXA-B.

Referring to FIG. 5A, the display panel DP may include the base layer BL, the circuit element layer DP-CL, the display element layer DP-OLED, and the thin film encapsulation layer TFE.

The display panel DP may include a plurality of insulating layers, a semiconductor pattern, a conductive pattern, and a signal line. An insulating layer, a semiconductor layer, and a conductive layer may be formed by a coating or depositing process. Then, the insulating layer, the semiconductor layer, and the conductive layer may be selectively patterned by a photolithography process and an etching process. The semiconductor pattern, the conductive pattern, and the signal line included in the circuit element layer DP-CL and the display element layer DP-OLED may be formed through the above processes.

The circuit element layer DP-CL may be located on the base layer BL. The circuit element layer DP-CL may include a buffer layer BFL, a transistor TR1, a signal transmission area SCL, first, second, third, fourth, fifth, and sixth insulating layers 10, 20, 30, 40, 50, and 60, an electrode UE, and a plurality of connection electrodes CNE1 and CNE2.

The buffer layer BFL may be located on the base layer BL. The buffer layer BFL may increase an adhesion between the base layer BL and the semiconductor pattern. The buffer layer BFL may include a silicon oxide layer and a silicon nitride layer, and the silicon oxide layer and the silicon nitride layer may be alternately stacked with each other.

The semiconductor pattern may be located on the buffer layer BFL. The semiconductor pattern may include polysilicon, however, it should not be limited thereto or thereby. The semiconductor pattern may include an amorphous silicon or metal oxide. FIG. 5A shows a portion of the semiconductor pattern, and the semiconductor pattern may be further located in the light-emitting areas PXA-R, and PXA-G (refer to FIG. 4). The semiconductor pattern may be arranged with a corresponding rule over the light-emitting areas PXA-R, PXA-G, and PXA-B. The semiconductor pattern may have different electrical properties depending on whether it is doped or not. The semiconductor pattern may include a first region having a relatively high doping concentration, and a second region having a relatively low doping concentration. The first region may be doped with the N-type dopant or the P-type dopant. A P-type transistor may include the first region doped with the P-type dopant.

The first region may have a conductivity that is greater than that of the second region, and may substantially serve as an electrode or a signal line. The second region may substantially correspond to an active (or a channel) of the transistor. In other words, a portion of the semiconductor pattern may be the active of the transistor, another portion of the semiconductor pattern may be a source or a drain of the transistor, and the other portion of the semiconductor pattern may be a conductive area.

A source S1, an active A1, and a drain D1 of the transistor TR1 may be formed from the semiconductor pattern. FIG. 5A shows a portion of the signal transmission area SCL formed from the semiconductor pattern. In one or more embodiments, the signal transmission area SCL may be connected to the drain D1 of the transistor TR1 in a plane.

The first, second, third, fourth, fifth, and sixth insulating layers 10, 20, 30, 40, 50, and 60 may be located on the buffer layer BFL. Each of the first to sixth insulating layers 10 to 60 may be an inorganic layer or an organic layer.

The first insulating layer 10 may be located on the buffer layer BFL. The first insulating layer 10 may cover the source S1, the active A1, and the drain D1 of the transistor TR1 and the signal transmission area SCL located on the buffer layer BFL. A gate G1 of the transistor TR1 may be located on the first insulating layer 10. The second insulating layer 20 may be located on the first insulating layer 10, and may cover the gate G1. The electrode UE may be located on the second insulating layer 20. The third insulating layer 30 may be located on the second insulating layer 20, and may cover the electrode UE.

A first connection electrode CNE1 may be located on the third insulating layer 30. The first connection electrode CNE1 may be connected to the signal transmission area SCL via a contact hole CNT-1 defined through the first, second, and third insulating layers 10, 20, and 30. The fourth insulating layer 40 may be located on the third insulating layer 30, and may cover the first connection electrode CNE1. The fourth insulating layer 40 may be an organic layer.

The fifth insulating layer 50 may be located on the fourth insulating layer 40, and a second connection electrode CNE2 may be located on the fifth insulating layer 50. The second connection electrode CNE2 may be connected to the first connection electrode CNE1 via a contact hole CNT-2 defined through the fourth and fifth insulating layers 40 and 50. The sixth insulating layer 60 may be located on the fifth insulating layer 50, and may cover the second connection electrode CNE2. Each of the fifth and sixth insulating layers 50 and 60 may be an organic layer. The fifth and sixth insulating layers 50 and 60 may provide a flat upper surface thereon.

The display element layer DP-OLED may be located on the circuit element layer DP-CL. The display element layer DP-OLED may include the light-emitting element ED, a pixel-defining layer PDL, and a support pattern SP.

The light-emitting element ED may include the first electrode AE, the first light-emitting pattern EL1, and a second electrode CE.

The first electrode AE may be located on the sixth insulating layer 60 of the circuit element layer DP-CL. The first electrode AE may be a transmissive electrode, a semi-transmissive electrode, or a reflective electrode. The first electrode AE may be the anode and may be connected to the second connection electrode CNE2 via a connection contact hole CNT-3 defined through the sixth insulating layer 60. Accordingly, the first electrode AE may be electrically connected to the signal transmission area SCL via the first and second connection electrodes CNE1 and CNE2, and may be electrically connected to a corresponding circuit element. The first electrode AE may have a single-layer or multi-layer structure. The first electrode AE may include plural layers containing ITO or Ag. As an example, the first electrode AE may include a layer (or a lower ITO layer) containing ITO, a layer (or an Ag layer) located on the lower ITO layer and containing Ag, and a layer (or an upper ITO layer) located on the Ag layer and containing ITO.

The support pattern SP may be located between the first electrode AE and the pixel-defining layer PDL. The support pattern SP may be provided with, or may define, a support opening OP-SP defined therethrough to expose a portion of an upper surface of the first electrode AE. The support opening OP-SP may overlap a pixel opening P-OP1 described later. The support pattern SP may have a multi-layer structure. As an example, the support pattern SP may include a lower support pattern SP1 located on the first electrode AE, and an upper support pattern SP2 located between the lower support pattern SP1 and the pixel-defining layer PDL.

The pixel-defining layer PDL may be located on the sixth insulating layer 60 of the circuit element layer DP-CL. The pixel-defining layer PDL may be provided with the pixel opening P-OP1 defined therethrough. As an example, at least a portion of the first electrode AE may be exposed through the pixel opening P-OP1 of the pixel-defining layer PDL. The pixel opening P-OP1 of the pixel-defining layer PDL may define the third light-emitting area PXA-B.

When viewed in the plane, the pixel opening P-OP1 may have a size that is smaller than a size of the support opening OP-SP. That is, an inner side surface of the pixel-defining layer PDL, which defines the pixel opening P-OP1, may be located closer to a center of the first electrode AE than an inner side surface of the support pattern SP, which defines the support opening OP-SP, is. In addition, the third light-emitting area PXA-B may be an area of the first electrode AE exposed through a corresponding pixel opening P-OP1.

The pixel-defining layer PDL may include an organic material. The pixel-defining layer PDL may include a light-blocking material, and may have a black color. As an example, the pixel-defining layer PDL may include a base resin, and a coloring material mixed with the base resin. As an example, the base resin may include at least one of an acrylic-based resin, a polyimide-based resin, and/or a siloxane-based resin. The coloring material may include a black pigment and/or a black dye. The coloring material may include a metal material, such as carbon black, chromium, or an oxide thereof.

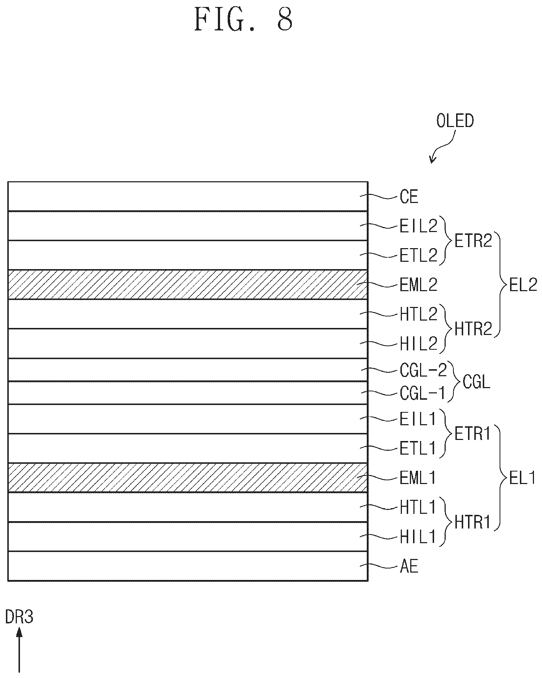

The first light-emitting pattern EL1 may be located on the first electrode AE. The first light-emitting pattern EL1 may include a first light-emitting layer (refer to EML1 of FIG. 8) including a light-emitting material. The first light-emitting pattern EL1 may be referred to as an organic layer or an intermediate layer. The structure of first light-emitting pattern EL1 will be described in detail later.

The second electrode CE may be located on the first light-emitting pattern EL1. The second electrode CE may have conductivity. The second electrode CE may be formed of a variety of materials, such as a metal material, a transparent conductive oxide (TCO), a conductive polymer material, etc., as long as the second electrode CE has the conductivity. As an example, the second electrode CE may include silver (Ag), magnesium (Mg), lead (Pb), copper (Cu), or compounds thereof.

The thin film encapsulation layer TFE may be located on the display element layer DP-OLED. The thin film encapsulation layer TFE may include a first inorganic encapsulation layer TIOL1, an organic encapsulation layer TOL, and a second inorganic encapsulation layer TIOL2. As an example, the thin film encapsulation layer TFE may further include an inorganic layer located between the first inorganic encapsulation layer TIOL1 and the organic encapsulation layer TOL, or the thin film encapsulation layer TFE may omit the organic encapsulation layer TOL.

The first inorganic encapsulation layer TIOL1 and the second inorganic encapsulation layer TIOL2 may protect the display element layer DP-OLED from moisture and oxygen, and the organic encapsulation layer TOL may protect the display element layer DP-OLED from a foreign substance, such as dust particles. In addition, the organic encapsulation layer TOL may serve as a planarization layer. The first inorganic encapsulation layer TIOL1 and the second inorganic encapsulation layer TIOL2 may include a silicon nitride layer, a silicon oxynitride layer, a silicon oxide layer, a titanium oxide layer, or an aluminum oxide layer. The organic encapsulation layer TOL may include an acryl-based organic layer, but it should not be limited thereto or thereby.

FIG. 5B is an enlarged cross-sectional view of an area AA' of FIG. 5A. In FIG. 5B, the same reference numerals denote the same elements in FIG. 5A, and thus, detailed descriptions of the same elements will be omitted. A concave area CA extending from the pixel opening P-OP1 to an inner side of the pixel-defining layer PDL may be defined in the pixel-defining layer PDL.

The support pattern SP may be located in the concave area CA, and the support pattern SP may include a lower support pattern SP1 located between the first electrode AE and the pixel-defining layer PDL, and an upper support pattern SP2 located between the lower support pattern SP1 and the pixel-defining layer PDL. One portion SP2-1 of the upper support pattern SP2 may overlap the lower support pattern SP1, and another portion SP2-2 of the upper support pattern SP2 may not overlap the lower support pattern SP1 (e.g., may be offset from the lower support pattern SP1 in plan view), and the portion SP2-1 of the upper support pattern SP2 and the other portion SP2-2 of the upper support pattern SP2 may be spaced apart from the first electrode AE.

The lower support pattern SP1 may include a conductive material. As an example, the lower support pattern SP1 may include a conductive oxide, and, for example, may include a transparent conductive oxide. The lower support pattern SP1 may include at least one of conductive oxides, such as indium tin oxide (ITO), indium zinc oxide (IZO), zinc oxide (ZnO), indium tin zinc oxide (ITZO), and/or indium gallium zinc oxide (IGZO).

The upper support pattern SP2 may include an inorganic insulating material. As an example, the upper support pattern SP2 may include at least one of inorganic insulating materials, such as silicon nitride (SiNₓ), silicon oxide (SiOₓ), silicon oxynitride (SiONₓ), and/or aluminum oxide (Al₂O₃). The upper support pattern SP2 may have high heat resistance and chemical resistance, and thus, the upper support pattern SP2 may reduce or prevent deformation of the pixel-defining layer PDL in high-temperature processes, and may support the pixel-defining layer PDL.

The first light-emitting pattern EL1 may include a first portion EL1-1 located on the pixel-defining layer PDL, and a second portion EL1-2 located in the pixel opening P-OP1. The lower support pattern SP1 may have a thickness H1 that is greater than a thickness H2 of the second portion EL1-2 of the first light-emitting pattern EL1, and that may be less than a sum H3 of a thickness of the second portion EL1-2 of the first light-emitting pattern EL1 and a thickness of the second electrode CE. Accordingly, the first portion EL1-1 of the first light-emitting pattern EL may be electrically insulated from the second portion EL1-2. Therefore, a lateral leakage current may be reduced between light-emitting areas PXA-R, PXA-G, and PXA-B, and the pixels may provide a light emission luminance corresponding to grayscale values.

The pixel-defining layer PDL may include a first portion PDL-P1 that does not overlap the first electrode AE and the support pattern SP, and a second portion PDL-P2 that overlaps the first electrode AE and the support pattern SP. The lower support pattern SP1 may be located between the first electrode AE and the second portion PDL-P2 of the pixel-defining layer PDL, and the upper support pattern SP2 may be located between the lower support pattern SP1 and the second portion PDL-P2 of the pixel-defining layer PDL.

When viewed in the plane, the other portion SP2-2 of the upper support pattern SP2 may extend further than the lower support pattern SP1, and may be spaced apart from the first electrode AE. That is, the upper support pattern SP2 may have a width L2 that is greater than a width L1 of the lower support pattern SP1. Accordingly, an empty space may be formed within the concave area CA from the second portion EL1-2 of the first light-emitting pattern EL1 to the inner side surface of the lower support pattern SP1. However, a size and shape of the empty space may vary depending on a deposition process for the first light-emitting pattern EL1, which will be described later.

FIG. 5C is a cross-sectional view of the display panel DP taken along the line II-II' of FIG. 4 according to one or more embodiments of the present disclosure. In this case, as shown in FIG. 5C, the concave area CA (refer to FIG. 5B) is not included in the pixel-defining layer PDL, and the support pattern SP (refer to FIG. 5B) is also omitted. Accordingly, the first light-emitting pattern EL1 may be located on the pixel-defining layer PDL and the first electrode AE without being electrically disconnected. The second electrode CE may be located on the first light-emitting pattern EL1 without being electrically disconnected, similar to the second electrode CE shown in FIG. 5B.

FIG. 5D is an enlarged plan view of the pixel PX of FIG. 3. When viewed in the plane, an area indicated by a dotted line corresponds to the first electrode AE surrounding the third light-emitting area PXA-B. The first electrode AE may include a first edge A-ED1, a second edge A-ED2 facing the first edge A-ED1 in the first direction DR1, a third edge A-ED3, and a fourth edge ED4 facing the third edge A-ED3 in the second direction DR2 crossing the first direction DR1. The concave area CA may be defined to correspond to at least one of the first edge A-ED1 to the fourth edge A-ED4. As an example, the concave area CA may include a first concave area CA1 defined to correspond to the first edge A-ED1 and a second concave area CA2 defined to correspond to the second edge A-ED2, as shown in FIG. 5D.

In one or more embodiments, because the support pattern SP is located in the concave area CA as described above, the support pattern SP may be located at the first edge A-ED1 and the second edge A-ED2. Accordingly, as shown in FIG. 5B, the first light-emitting pattern EL1 located on the first edge A-ED1 may be electrically insulated from the first light-emitting pattern EL1 located on the second edge A-ED2, and thus, the lateral leakage current may decrease. That is, the first portion EL1-1 of the first light-emitting pattern EL1 may be electrically insulated from the second portion EL1-2 of the first light-emitting pattern EL1. On the other hand, as shown in FIG. 5C, the first light-emitting pattern EL1 located on the third edge A-ED3 and the first light-emitting pattern EL1 located on the fourth edge A-ED4 may be electrically connected to each other in the second direction DR2, and thus, a current path may be sufficiently secured.

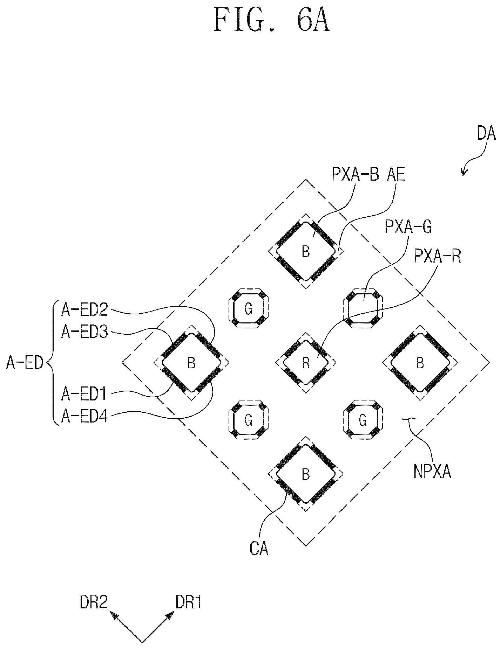

FIGS. 6A to 6C are enlarged plan views of a portion of a display area DA according to embodiments of the present disclosure.

Referring to FIG. 6A, each of a first light-emitting area PXA-R and a third light-emitting area PXA-B may have a rounded quadrangular shape, and an area of a first electrode AE surrounding each of the first light-emitting area PXA-R and the third light-emitting area PXA-B may have a quadrangular shape with four edges. A concave area CA may be defined to correspond to all edges A-ED of the first electrode AE of each of the first light-emitting area PXA-R and the third light-emitting area PXA-B. Accordingly, the concave area CA may be defined in all of first, second, third, and fourth edges A-ED1, A-ED2, A-ED3, and A-ED4 of the corresponding first electrodes AE. On the other hand, a second light-emitting area PXA-G may have an octagonal shape, and an area of the first electrode AE surrounding the second light-emitting area PXA-G may also have an octagonal shape with eight edges. The concave area CA may be defined to correspond to some of edges of the first electrode AE surrounding the second light-emitting area PXA-G. As an example, the concave area CA may be defined in the edges of the first electrode AE surrounding the second light-emitting area PXA-G closest to the first light-emitting area PXA-R and the third light-emitting area PXA-B. That is, the concave area CA may be defined in the edges of the first electrode AE of the second light-emitting area PXA-G, which are substantially parallel to the first direction DR1 and the second direction DR2. First light-emitting patterns EL1 (refer to FIG. 5B) respectively included in pixels adjacent to each other may be insulated from each other by a support pattern SP (refer to FIG. 5B) located in the concave area CA. Accordingly, a leakage current between adjacent pixels may be suppressed, and thus, excessive concentration of current in a corresponding pixel may be reduced or prevented.

Depending on a thickness of the support pattern SP (refer to FIG. 5B) included in the concave area CA, a second electrode CE (refer to FIG. 5B) may be electrically disconnected in some edges. As the concave area CA is not located at the other edges of the second light-emitting area PXA-G, the likelihood of the second electrode CE (refer to FIG. 5B) being electrically disconnected may be reduced or prevented.

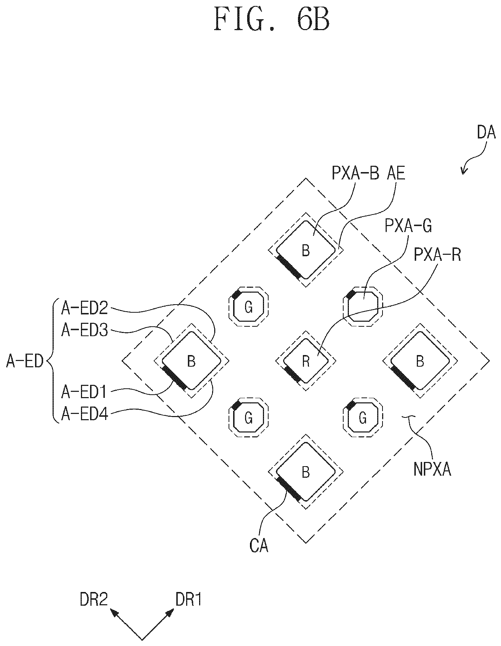

Referring to FIG. 6B, a concave area CA may be located at only one of the edges of a first electrode AE surrounding first, second, and/or third light-emitting areas PXA-R, PXA-G, and/or PXA-B. As an example, the concave area CA may be located to correspond to only a first edge A-ED1, which extends in parallel to the second direction DR2, among the edges of the first electrodes AE surrounding the first light-emitting area PXA-R and the third light-emitting area PXA-B. The concave area CA may be located to correspond to only a third edge A-ED3, which is parallel to the first direction DR1, among edges of the first electrode AE surrounding the second light-emitting area PXA-G.

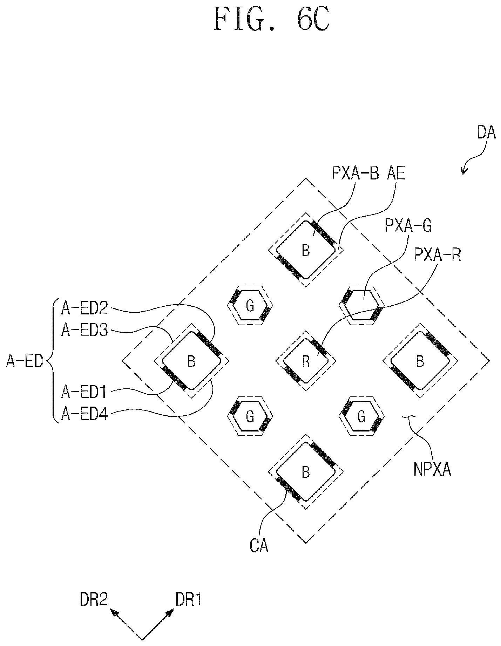

Referring to FIG. 6C, a second light-emitting area PXA-G may have a hexagonal shape, and a first electrode AE surrounding the second light-emitting area PXA-G may also have the hexagonal shape. A concave area CA may be located to correspond to a first edge A-ED1 and a second edge A-ED2 of the first electrode AE surrounding each of a first light-emitting area PXA-R and a third light-emitting area PXA-B, and may be located to correspond to edges, which face each other in the second direction DR2, of the first electrode AE surrounding the second light-emitting area PXA-G. The concave area CA and a support pattern SP (refer to FIG. 5B) may be located at some edges of the first electrode AE of the first, second, and third light-emitting areas PXA-R, PXA-G, and PXA-B adjacent to each other, and the concave area CA and the support pattern SP (refer to FIG. 5B) may not be located at the other edges of the first, second, and third light-emitting areas PXA-R, PXA-G, and PXA-B adjacent to each other. Accordingly, a lateral leakage current may be controlled, and also, a path for the second electrode CE (refer to FIG. 5B) may be sufficiently secured. Thus, the uniformity of the current path may be improved.

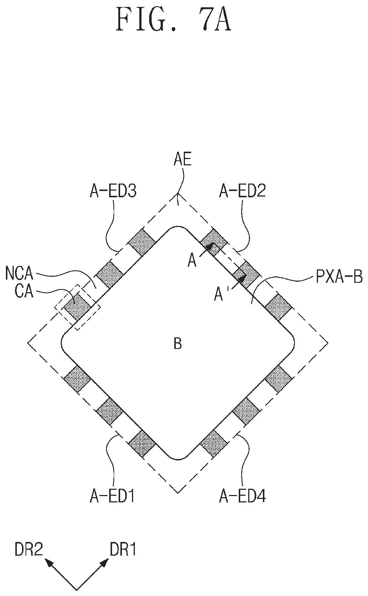

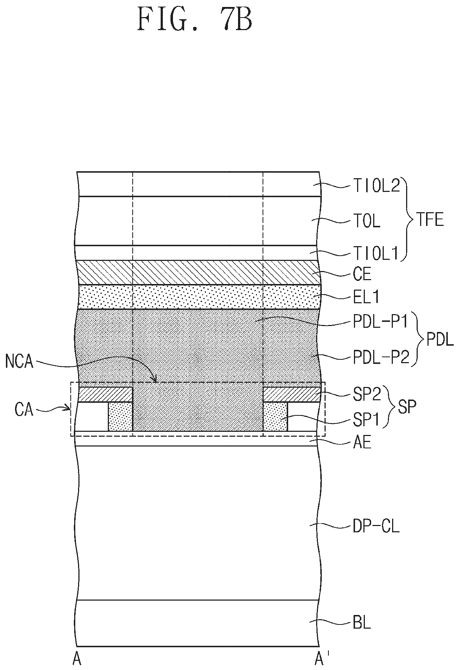

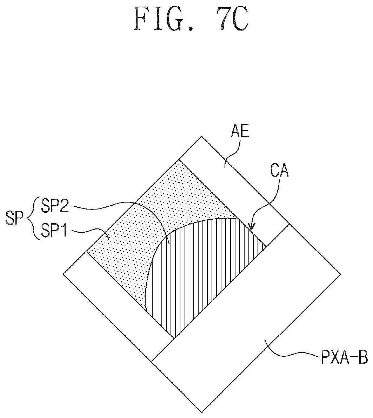

FIG. 7A is an enlarged plan view of a pixel (refer to FIG. 3) according to one or more embodiments of the present disclosure, FIG. 7B is a cross-sectional view taken along the line A-A' of FIG. 7A, and FIG. 7C is an enlarged plan view of a concave area CA of FIG. 7A.

Referring to FIG. 7A, plural concave areas CA may be located to correspond to at least one edge among first, second, third, and/or fourth edges A-ED1, A-ED2, A-ED3, and A-ED4 of a first electrode AE. As an example, three concave areas CA may be located at the first edge A-ED1. An area defined between the concave areas CA adjacent to each other among the concave areas CA may be defined as a non-concave area NCA. That is, each of the concave areas CA may be alternately arranged with the non-concave area NCA at the first edge A-ED1. The concave area CA may have substantially the same size as that of the non-concave area NCA, however, it should not be limited thereto or thereby.

Referring to FIG. 7B, a pixel-defining layer PDL may be in contact with the first electrode AE in the non-concave area NCA between the concave areas CA adjacent to each other. As described with reference to FIG. 5B, a first portion PDL-P1 of the pixel-defining layer PDL may correspond to the non-concave area NCA, and a second portion PDL-P2 of the pixel-defining layer PDL may correspond to the concave area CA. That is, the second portion PDL-P2 of the pixel-defining layer PDL may be provided in plural, the plural second portions PDL-P2 may be located to correspond to at least one edge of the first edge A-ED1 to the fourth edge A-ED4, and the first portion PDL-P1 may be located between the second portions PDL-P2 adjacent to each other among the second portions PDL-P2.

In addition, a support pattern SP may be provided in plural, and the support patterns SP may be located to correspond to the concave areas CA, respectively. The support pattern SP may be omitted from the non-concave area NCA between adjacent concave areas CA, and thus, a size of the support pattern SP may be reduced. Accordingly, a size of an undercut shape defined at a lower side of the pixel-defining layer PDL may be reduced. That is, a structural stability of the pixel-defining layer may be improved when the plural support patterns SP2 are alternately arranged to correspond to the edges A-ED of the first electrode AE compared to when a single support pattern SP is formed to correspond to the edges A-ED of the first electrode AE.

FIG. 7C is an enlarged plan view of the concave area CA of FIG. 7A, and the support pattern SP may be located in the concave area CA. A lower support pattern SP1 may be isotropically etched by a wet etch process, which will be described later. That is, because the lower support pattern SP1 may be etched at the same rate in all directions, the lower support pattern SP1 may be formed in a curve with a concave center when viewed in the plane. Therefore, stress applied to the lower support pattern SP1 may be distributed substantially evenly, and thus, the structural stability of the support pattern SP may be improved.

FIG. 8 is an enlarged cross-sectional view of a portion of a light-emitting element OLED according to one or more embodiments of the present disclosure.

Referring to FIG. 8, the light-emitting element OLED may include a first electrode AE, a first light-emitting pattern EL1, a charge generation layer CGL, a second light-emitting pattern EL2, and a second electrode (or a common electrode) CE. The light-emitting element OLED may be a light-emitting element of a tandem structure including multiple light-emitting patterns EL1 and EL2 including light-emitting layers.

The first light-emitting pattern EL1 may include a first light-emitting layer EML1, a first hole control layer HTR1, and a first electron control layer ETR1 spaced apart from the first hole control layer HTR1 with the first light-emitting layer EML1 interposed therebetween.

The first hole control layer HTR1 may include at least one of a first hole injection layer HIL1 or a first hole transport layer HTL1. The first hole transport layer HTL1 may include at least one of a first hole buffer layer or a first electron-blocking layer.

The first electron control layer ETR1 may include at least one of a first electron injection layer EIL1 or a first electron transport layer ETL1. The first electron control layer ETR1 may further include a first hole-blocking layer.

The second light-emitting pattern EL2 may include a second light-emitting layer EML2, a second hole control layer HTR2, and a second electron control layer ETR2 spaced apart from the second hole control layer HTR2 with the second light-emitting layer EML2 interposed therebetween.

The second hole control layer HTR2 may include at least one of a second hole injection layer HIL2 or a second hole transport layer HTL2. The second electron control layer ETR2 may include at least one of a second electron injection layer EIL2 or a second electron transport layer ETL2. Descriptions on the first hole control layer HTR1 and the first electron control layer ETR1 may be applied equally to the second hole control layer HTR2 and the second electron control layer ETR2.

The light-emitting patterns EL1 and EL2 may emit lights having the same wavelength as each other. As an example, the light emitted from each of the light-emitting patterns EL1 and EL2 may be a blue light, however, embodiments of the present disclosure should not be limited thereto or thereby. According to one or more embodiments, the lights emitted from the light-emitting patterns EL1 and EL2 may have different wavelength ranges from each other. As an example, at least one of the light-emitting patterns EL1 or EL2 may emit the blue light, and the other of the light-emitting patterns EL1 or EL2 may emit a green light. The light-emitting element OLED including the light-emitting patterns EL1 and EL2 emitting the lights having different wavelength ranges from each other may emit a white light.

The charge generation layer CGL may be located between the first light-emitting pattern EL1 and the second light-emitting pattern EL2. When a voltage is applied, the charge generation layer CGL may form a complex through an oxidation-reduction reaction, and thus may generate charges (electrons and holes). In addition, the charge generation layer CGL may provide the generated charges to each of the light-emitting patterns EL1 and EL2 adjacent thereto. The charge generation layer CGL may double the efficiency of current generated in each of the light-emitting patterns EL1 and EL2 and may adjust a balance of the charges between the first light-emitting pattern EL1 and the second light-emitting pattern EL2.

In more detail, the charge generation layer CGL may have a layer structure in which a lower charge generation layer CGL-1 is bonded to an upper charge generation layer CGL-2. The lower charge generation layer CGL-1 may be an n-type charge generation layer that is located adjacent to the first light-emitting pattern EL1, and may provide electrons to the first light-emitting pattern EL1. The lower charge generation layer CGL-1 may include an aryl amine-based organic compound.

The upper charge generation layer CGL-2 may be a p-type charge generation layer that is located adjacent to the second light-emitting pattern EL2 and provides holes to the second light-emitting pattern EL2. The upper charge generation layer CGL-2 may include a charge-generating compound containing a metal, an oxide of a metal, a carbide, a fluoride, or a mixture thereof. A buffer layer may be further located between the lower charge generation layer CGL-1 and the upper charge generation layer CGL-2.

The first light-emitting pattern EL1, the charge generation layer CGL, and the second light-emitting pattern EL2 may be commonly formed over the pixels using an open mask, however, embodiments of the present disclosure should not be limited thereto or thereby. According to one or more embodiments, at least one of the first and second hole control layers HTR1 or HTR2, the first and second light-emitting layers EML1 and EML2, and the first and second electron control layers ETR1 and ETR2 may be formed through a patterning process using a mask. As an example, each of the first and second light-emitting layers EML1 and EML2 may be located in an area overlapping a pixel opening P-OP1 (refer to FIG.5C). That is, each of the first and second light-emitting layers EML1 and EML2 may be formed in each pixel after being divided into plural portions.

The second electrode CE may be located on the second light-emitting pattern EL2. The second electrode CE may have an integral shape and may be commonly located over the pixels.

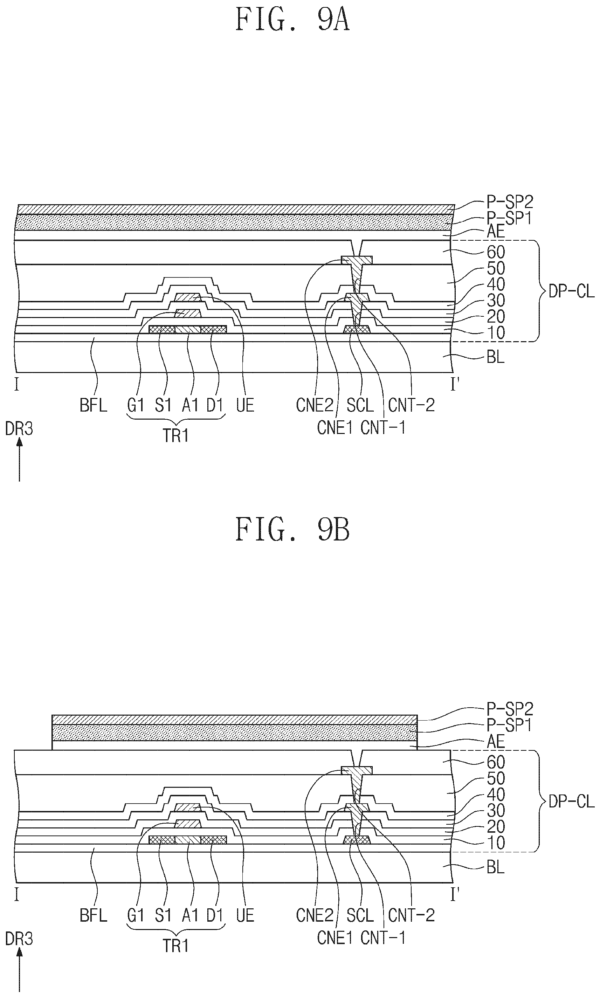

FIGS. 9A to 9G are cross-sectional views of a method of manufacturing the display device according to one or more embodiments of the present disclosure. Hereinafter, FIGS. 9A to 9G are illustrated based on the display panel DP of FIG. 5A, and detailed descriptions of the elements that are the same as those described with reference to FIG. 5A will be omitted.

Referring to FIG. 9A, the circuit element layer DP-CL may be located on the base layer BL. The circuit element layer DP-CL may be formed by a manufacturing method of the circuit element, such as selectively patterning the insulating layer, the semiconductor layer, and the conductive layer, thereby forming the semiconductor pattern, the conductive pattern, the signal line, etc. The transistor TR1 and each of the insulating layers 10 to 60 may be formed by a deposition process of an inorganic material or an organic material.

The first electrode AE, a preliminary lower support pattern P-SP1, and a preliminary upper support pattern P-SP2 may be formed on the circuit element layer DP-CL. The first electrode AE, the preliminary lower support pattern P-SP1, and the preliminary upper support pattern P-SP2 may be formed through a deposition process.

Referring to FIG. 9B, the first electrode AE, the preliminary lower support pattern P-SP1, and the preliminary upper support pattern P-SP2 may be patterned by a photolithography process to expose a portion of the sixth insulating layer 60 included in the circuit element layer DP-CL.

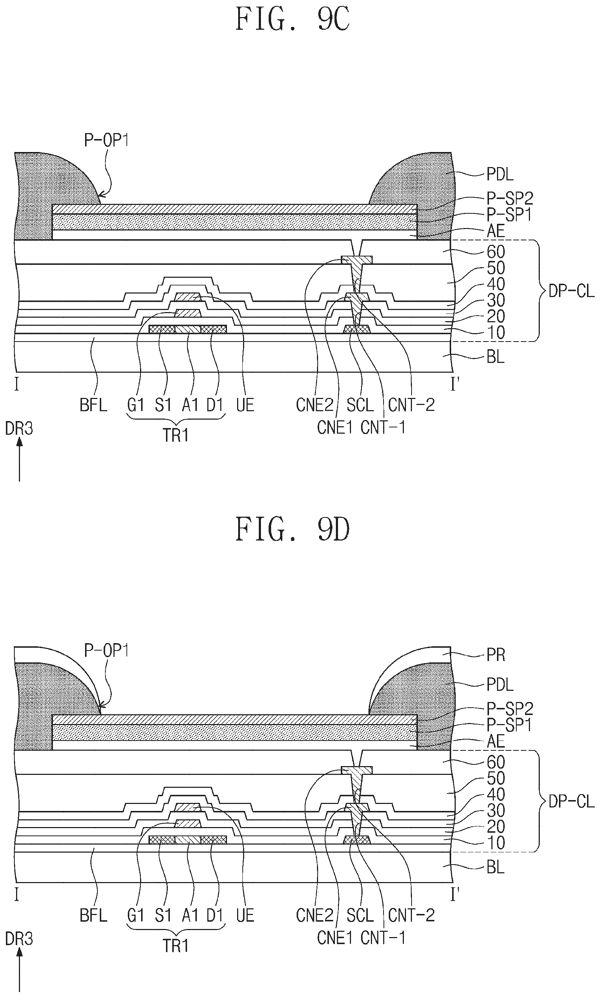

Referring to FIG. 9C, the pixel-defining layer PDL may be formed to cover the exposed portion of the sixth insulating layer 60. The pixel opening P-OP1 may be defined through the pixel-defining layer PDL to expose the portion of the first electrode AE, and may be defined on the preliminary lower support pattern P-SP1 and the preliminary upper support pattern P-SP2.

The pixel-defining layer PDL may include a negative-type photosensitive resin material. A negative-type photosensitive resin layer is formed, and then the negative-type photosensitive resin layer is exposed and developed using a mask, and thus the pixel-defining layer PDL, which is patterned, may be formed. A portion of the negative-type photosensitive resin layer, which is not exposed to light, may be removed through an etching process. The pixel-defining layer PDL is described as including the negative-type photosensitive resin material as a representative example, however, embodiments of the present disclosure should not be limited thereto or thereby. According to one or more embodiments, the pixel-defining layer PDL may include a positive-type photosensitive resin material.

Referring to FIG. 9D, a photoresist layer PR may be formed on the pixel-defining layer PDL. in one or more embodiments, the photoresist layer PR may be formed by forming a preliminary photoresist layer and patterning the preliminary photoresist layer using a photomask.

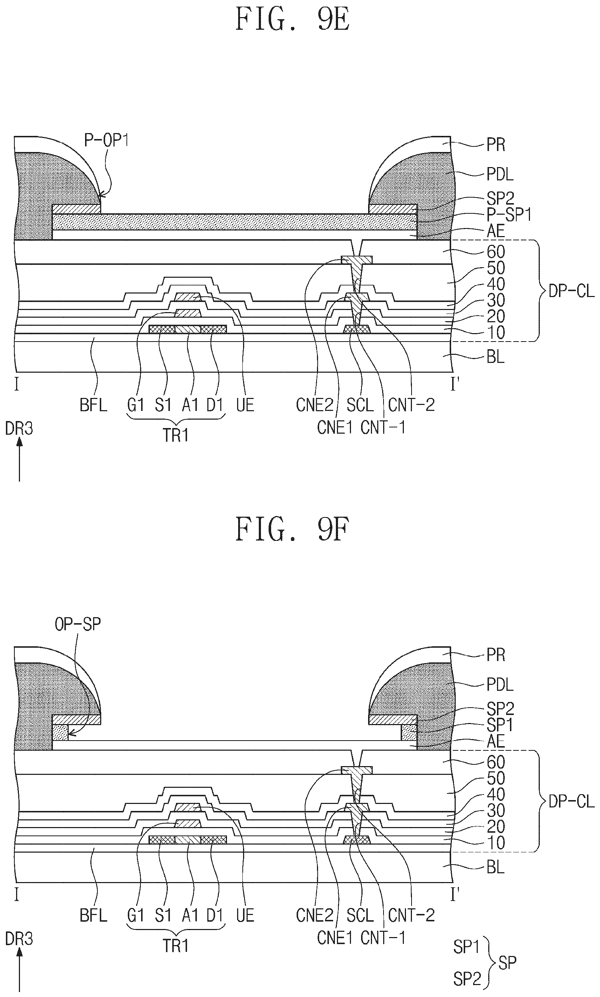

Referring to FIG. 9E, a portion of the preliminary upper support pattern P-SP2 may be etched to form the upper support pattern SP2. The preliminary upper support pattern P-SP2 may be etched by a dry etching process. Accordingly, the portion of the preliminary upper support pattern P-SP2, which corresponds to the pixel opening P-OP1, may be removed.

Referring to FIG. 9F, a portion of the preliminary lower support pattern P-SP1 may be etched to form the lower support pattern SP1. The preliminary lower support pattern P-SP1 may be etched by a wet etching process. Therefore, the support opening OP-SP may be formed to overlap the pixel opening P-OP1. That is, the portion of the preliminary lower support pattern P-SP1, which corresponds to the support opening OP-SP, may be removed. In addition, an etch rate of the preliminary upper support pattern P-SP2 may be different from an etch rate of the preliminary lower support pattern P-SP1, and the etch rate of the preliminary lower support pattern P-SP1 may be faster than the etch rate of the preliminary upper support pattern P-SP2. Accordingly, due to the difference in etch rate, the lower support pattern SP1 and the upper support pattern SP2 may be formed without using an additional mask.

Referring to FIGS. 7C and 9F, the preliminary lower support pattern P-SP1 may be isotropically etched to form the lower support pattern SP1. Accordingly, the lower support pattern SP1 may be undercut more than the upper support pattern SP2.

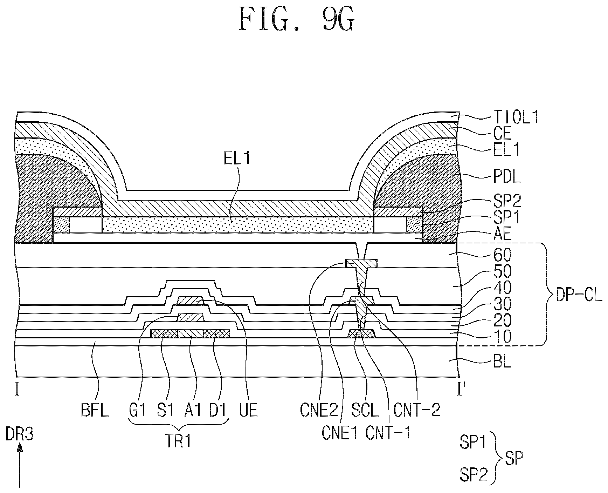

Referring to FIG. 9G, the photoresist layer PR may be removed, and the first light-emitting pattern EL1 may be formed on the portion of the first electrode AE and the pixel-defining layer PDL. The first light-emitting pattern EL1 located directly on the pixel-defining layer PDL may be electrically insulated from, or separated from, the first light-emitting pattern EL1 located directly on the first electrode AE due to the support pattern SP. The second electrode CE may be formed on the first light-emitting pattern EL1 and may have the integral shape. In addition, the first inorganic encapsulation layer TIOL1 may be formed on the second electrode CE to cover the second electrode CE, and thus, the second electrode CE may be protected from moisture and oxygen. Then, as shown in FIG. 5A, the organic encapsulation layer TOL and the second inorganic encapsulation layer TIOL2 may be formed on the first inorganic encapsulation layer TIOL1, and the display panel DP is completed.

As discussed, embodiments can provide a display device comprising: a base layer; a first electrode above the base layer; a pixel-defining layer above the base layer, the pixel-defining layer defining a pixel opening through which the first electrode is exposed, and the pixel-defining layer comprising a concave area extending from the pixel opening to an inner side of the pixel-defining layer; a support pattern above the first electrode in the concave area, the support pattern comprising: a lower support pattern between the first electrode and the pixel-defining layer; and an upper support pattern between the lower support pattern and the pixel-defining layer, wherein one portion of the upper support pattern overlaps the lower support pattern, and another portion of the upper support pattern is offset from the lower support pattern in plan view and is spaced apart from the first electrode; a first light-emitting pattern above the first electrode; and a second electrode above the first light-emitting pattern.

The display device may comprise a plurality of pixels, each pixel having a pixel opening.

The concave area may extend from the pixel opening to an inner side of the pixel-defining layer may be defined in the pixel-defining layer. In some embodiments, the concave area corresponds to a portion of the pixel-defining layer in which there is space for the support portion. Other portions of the pixel-defining layer that define the pixel opening may have no concave area.

When considered in plan view, the pixel opening may be associated with one or more concave areas. For example, a pixel may have a closed loop shape with a number of edge regions of the pixel opening. In such a case, one or more concave areas may be provided on one or more edge regions of the pixel opening.

The pixel-defining layer may overlap with the support pattern. In some embodiments, the concave area overlaps with the lower support pattern and the upper support pattern.

The lower support pattern may be made from a conductive material.

The upper support pattern may be made from an insulating material, e.g. an inorganic insulating material.

A portion of the upper support pattern may overlap with the lower support pattern, and another of the upper support pattern may extend from the inner side surface of the lower support pattern towards the center of the pixel opening.

An empty space may be formed within the concave area from a portion the first light-emitting pattern to the inner side surface of the lower support pattern.

The first light-emitting pattern may include a first portion located on the concave area of the pixel-defining layer, and a second portion located in the pixel opening. In the region of the concave area, the first portion of the first light-emitting pattern may be electrically insulated from the second portion. The lower support pattern may have a thickness that is greater than a thickness of the second portion of the first light-emitting pattern, and that may be less than a sum of a thickness of the second portion of the first light-emitting pattern and a thickness of the second electrode.

Embodiments can provide an electronic device comprising: a window; a housing coupled with the window; and a display module under the window, the display module comprising a display device according to any one of the above mentioned embodiments.

As discussed, embodiments can provide an electronic device comprising: a window; a housing coupled with the window; and a display module under the window, the display module comprising: a base layer; a first electrode above the base layer; a pixel-defining layer above the base layer, defining a pixel opening through which the first electrode is exposed, and comprising: a first portion offset from the first electrode in plan view; and a second portion overlapping the first electrode; wherein an upper support pattern between the lower support pattern and the second portion, and comprising a portion extending further than the lower support pattern and spaced apart from the first electrode; a first light-emitting pattern above the first electrode; and a second electrode above the first light-emitting pattern.

As discussed, embodiments can provide a method of manufacturing a display device, the method comprising: forming a first electrode, a preliminary upper support pattern, and a preliminary lower support pattern above a base layer; forming a pixel-defining layer defining a pixel opening exposing the first electrode above the preliminary upper support pattern and the preliminary lower support pattern; etching the preliminary upper support pattern to form an upper support pattern overlapping the pixel-defining layer; etching the preliminary lower support pattern to form a lower support pattern that is overlapped by a portion of the upper support pattern, and that is offset from another portion of the upper support pattern in plan view, the other portion of the upper support pattern being spaced apart from the first electrode; and forming a first light-emitting pattern and a second electrode above the pixel-defining layer and the first electrode.

Although embodiments of the present disclosure have been described, it is understood that the present disclosure should not be limited to these embodiments but various changes and modifications can be made by one ordinary skilled in the art within the scope of the present disclosure as hereinafter claimed. Therefore, the disclosed subject matter should not be limited to any single embodiment described herein, and the scope of the present disclosure shall be determined according to the attached claims, with functional equivalents thereof to be included therein.

## Claims

1. A display device comprising:
a base layer;
a first electrode above the base layer;
a pixel-defining layer above the base layer, the pixel-defining layer defining a pixel opening through which the first electrode is exposed, and the pixel-defining layer comprising a concave area extending from the pixel opening to an inner side of the pixel-defining layer;
a support pattern above the first electrode in the concave area, the support pattern comprising:
a lower support pattern between the first electrode and the pixel-defining layer; and
an upper support pattern between the lower support pattern and the pixel-defining layer, wherein one portion of the upper support pattern overlaps the lower support pattern, and another portion of the upper support pattern is offset from the lower support pattern in plan view and is spaced apart from the first electrode;
a first light-emitting pattern above the first electrode; and
a second electrode above the first light-emitting pattern.

2. The display device of claim 1, wherein the lower support pattern comprises a conductive material.

3. The display device of claim 1 or 2, wherein the upper support pattern comprises an inorganic insulating material.

4. The display device of any one of claims 1 to 3, wherein the first light-emitting pattern further comprises at least one of a hole control layer or an electron control layer.

5. The display device of any one of claims 1 to 4, further comprising:
a charge generation layer above the first light-emitting pattern; and
a second light-emitting pattern above the charge generation layer.

6. The display device of any one of claims 1 to 5, wherein the first light-emitting pattern comprises:
a first portion above the pixel-defining layer; and
a second portion in the pixel opening, wherein the second portion is electrically insulated from the first portion;
optionally wherein the lower support pattern has a thickness that is greater than a thickness of the second portion of the first light-emitting pattern, and that is less than a sum of the thickness of the second portion of the first light-emitting pattern and a thickness of the second electrode.

7. The display device of any one of claims 1 to 6, wherein the first electrode comprises a first edge, a second edge facing the first edge in a first direction in plan view, a third edge, and a fourth edge facing the third edge in a second direction crossing the first direction in plan view, and
wherein the concave area corresponds to only one of the first, second, third, or fourth edges.

8. The display device of any one of claims 1 to 5, wherein the first electrode comprises a first edge, a second edge facing the first edge in a first direction in plan view, a third edge, and a fourth edge facing the third edge in a second direction crossing the first direction in plan view, and
wherein the concave area comprises a first concave area corresponding to the first edge, and a second concave area corresponding to the second edge;
optionally wherein the first light-emitting pattern comprises: a first portion above the pixel-defining layer; and a second portion in the pixel opening, wherein the second portion is electrically insulated from the first portion in the first direction, and electrically connected to the first portion in the second direction.

9. The display device of claim 8, wherein the concave area further comprises:
a third concave area corresponding to the third edge; and
a fourth concave area corresponding to the fourth edge.

10. The display device of any one of claims 1 to 6, wherein the first electrode comprises a first edge, a second edge facing the first edge in a first direction in plan view, a third edge, and a fourth edge facing the third edge in a second direction crossing the first direction in plan view,
wherein the concave area is provided in plurality to correspond to at least one of the first, second, third, or fourth edges, and
wherein the pixel-defining layer contacts the first electrode between adjacent ones of the concave areas;
optionally wherein the support pattern is provided in plurality, the support patterns respectively corresponding to the concave areas, and not located between the adjacent ones of the concave areas.

11. The display device of any one of claims 1 to 5, wherein the pixel-defining layer further comprises:
a first portion offset from the first electrode in plan view; and a second portion overlapping the first electrode; and
wherein the upper support pattern further comprises a portion extending further than the lower support pattern and spaced apart from the first electrode.

12. The display device of claim 11, wherein the upper support pattern has a width that is greater than a width of the lower support pattern.

13. An electronic device comprising:
a window;
a housing coupled with the window; and
a display module under the window, the display module comprising a display device according to any one of claims 1 to 12.

14. A method of manufacturing a display device, the method comprising:
forming a first electrode, a preliminary upper support pattern, and a preliminary lower support pattern above a base layer;
forming a pixel-defining layer defining a pixel opening exposing the first electrode above the preliminary upper support pattern and the preliminary lower support pattern;
etching the preliminary upper support pattern to form an upper support pattern overlapping the pixel-defining layer;
etching the preliminary lower support pattern to form a lower support pattern that is overlapped by a portion of the upper support pattern, and that is offset from another portion of the upper support pattern in plan view, the other portion of the upper support pattern being spaced apart from the first electrode; and
forming a first light-emitting pattern and a second electrode above the pixel-defining layer and the first electrode.

15. The method of claim 14, wherein the etching of the preliminary upper support pattern comprises a dry etching process, and wherein the etching of the preliminary lower support pattern comprises a wet etching process; or
wherein the etching of the preliminary lower support pattern comprises isotropic etching.
